Europäisches Patentamt

European Patent Office

Office européen des brevets

(11) Veröffentlichungsnummer: **0 491 217 A1**

## (12) EUROPÄISCHE PATENTANMELDUNG

(21) Anmeldenummer: **91120695.1**

(22) Anmeldetag: **02.12.91**

(51) Int. Cl.5: **H01L 27/06**, H01L 27/07, H01L 27/02

(30) Priorität: **19.12.90 DE 4040754**

(43) Veröffentlichungstag der Anmeldung:
**24.06.92 Patentblatt 92/26**

(84) Benannte Vertragsstaaten:
**DE FR GB IT**

(71) Anmelder: **SIEMENS AKTIENGESELLSCHAFT**
**Wittelsbacherplatz 2**
**W-8000 München 2(DE)**

(72) Erfinder: **Pernerstorfer, Peter, Dipl.-Phys.**
**Balanstrasse 101/III**
**W-8000 München 90(DE)**

(54) **Integrierte Transistor-Freilaufdioden-Anordnung.**

(57) Die Erfindung betrifft die Anordnung eines bipolaren Leistungstransistors mit der zugehörigen Freilaufdiode in integrierten Schaltungen. Ein Leistungstransistor ist in mehrere parallel geschaltete Einzeltransistoren aufgeteilt. Die Freilaufdiode besteht ebenfalls aus parallelgeschalteten Einzeldioden. Jedem Einzeltransistor ist eine Einzeldiode benachbart angeordnet. Die Anschlüsse beider Elemente sind so verbunden, daß die Versorgung über die selben Stromschienen erfolgt.

FIG 3

Die Erfindung betrifft eine bipolare Transistoranordnung mit zugehöriger Freilaufdiode gemäß dem Oberbegriff des Anspruchs 1.

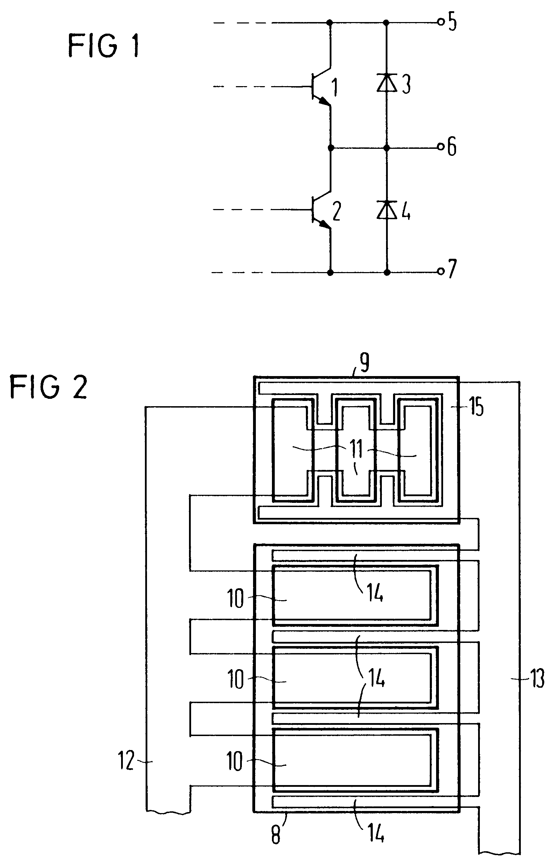

Derartige Anordnungen werden vor allem bei Leistungsendstufen in integrierten Schaltungen benötigt. Figur 1 zeigt eine derartige Leistungsendstufe, die als sogenannte Halbbrückenschaltung ausgebildet ist. Eine solche Leistungs-Halbbrücke dient z.B. dazu, Magnete, Motoren und andere induktive Verbraucher zu steuern. Vor allem bei induktiven Verbrauchern müssen parallel zu den Quellen- und Senkentransistoren der Leistungsendstufen Freilaufdioden geschaltet werden. Ein derartiger Quellentransistor ist in Figur 1 mit 1 und der Senkentransistor mit 2 bezeichnet. Die zugehörigen Freilaufdioden für den Quellentransistor 1 ist mit 3 und für den Senkentransistor 2 mit 4 bezeichnet. An der Klemme 5 wird die Versorgungsspannung zugeführt und an dem Ausgang 6 kann der gesteuerte Ausgangsstrom abgegriffen werden. Pin 7 liegt auf Masse (= Substrat). Der Emitteranschluß kann auf Masse oder auf niedrigem Potential liegen. Die als Leistungsdioden ausgebildeten Freilaufdioden gewährleisten den Freilauf des durch die Induktivität erzeugten Abschaltstromes durch beide Halbbrückenteile ohne Beeinflussung der vorgeschalteten integrierten Ansteuerschaltung.

Bei der Integration derartiger Anordnungen bestehen die Leistungsbauelemente, wie Transistoren und Freilaufdioden jeweils aus einer Vielzahl von parallelgeschalteten Einzeltransistoren bzw. Einzelfreilaufdioden. Diese wurden bisher zu jeweils einzelnen Blöcken zusammengefaßt und räumlich voneinander getrennt auf dem Halbleitersubstrat angeordnet.

Ein derartiges typisches Layout ist in Figur 2 dargestellt. Sie zeigt die Draufsicht auf einen Ausschnitt eines Halbleiterbaustein mit Leistungstransistor 8, Freilaufdiode 9 sowie zugehörigen Stromzuleitungen 12, 13. Jeder Leistungstransistor 8 ist aus mehreren parallelgeschalteten Einzeltransistoren, deren Emitteranschlußbereiche schematisch mit 10 und deren Kollektoranschlußbereiche schematisch mit 14 bezeichnet sind, aufgebaut. Ebenso besteht die Leistungsfreilaufdiode 9 aus mehreren parallelgeschalteten Einzelfreilaufdioden, deren einzelne Kathodenanschlußbereiche mit 11 und die Anodenanschlußbereiche mit 15 bezeichnet sind. Handelt es sich um einen Quellentransistor 1 mit zugehöriger Freilaufdiode 3 entsprechend Figur 1, so erfolgt die Verbindung der Kollektoranschlußbereiche 14 mit der Versorgungsspannung über fingerförmige Abzweigungen, die die Kollektoranschlußbereiche 14 mit dem Versorgungsspannungsleiter 13 versorgen. Diese führen entsprechend Figur 1 zur Anschlußklemme 5. Eine zusätzliche Abzweigung von dem Versorgungsspannungsleiter 13 ist notwendig, um den Anodenanschlußbereich 15 der Freilaufdiode 9 mit dem Versorgungsspannungsleiter 13 zu verbinden. Der zweite Leiter 12 verbindet auf ähnliche Weise die Emitteranschlußbereiche 10 des Leistungstransistors mit dem Ausgangsanschluß, in Figur 1 mit 6 bezeichnet, über fingerförmige Abzweigungen. Hier ist ebenso eine zusätzliche Abzweigung notwendig, um den Kathodenbereich 11 der Freilaufdiode mit dem Leiter 12 zu verbinden. Handelt es sich bei dem Leistungstransistor 8 um den Senkentransistor 2 und bei der Freilaufdiode um die Diode 4 entsprechend Figur 1, so verbindet der Leiter 13 die Kollektoranschlußbereiche der Transistoren und die Kathodenbereiche der Dioden mit der in Figur 1 mit 6 bezeichneten Ausgangsklemme. Dementsprechend verbindet Leiter 12 die Emitter- und Anodenbereiche mit der in Figur 1 mit 7 bezeichneten Anschlußklemme.

Durch die örtliche Trennung von Transistorblock und Diodenblock entsteht ein erheblicher Platzbedarf, der sich aus Bauelementefläche und Verdrahtungsfläche zusammensetzt. Weiter ergibt sich durch die verlängerten Anschlußleiter an diesem ein erhöhter Spannungsabfall, der sich negativ auf die Diode oder, je nach Anschlußlage, auf den Transistor auswirkt. Außerdem führt die Konzentration der Einzeldioden in einem Block bei Belastung zu erheblichen lokalen Erwärmungen, die schlechter als verteilte thermische Entwicklungen abgeführt werden können.

Leistungsbauelemente wie Endstufentransistoren, Freilaufdioden und die Verdrahtung von Leistungsbauelementen haben einen prozentual hohen Anteil an der Gesamtchipfläche. Aus Kostengründen ist die Fläche der Bauteile so klein wie möglich zu halten. Aus elektrischen Gründen sind die Verbindungen so kurz wie möglich zu halten und aus thermischen Gründen ist eine Verteilung belasteter Strukturen zu erstreben.

Aufgabe der Erfindung ist es daher, eine Anordnung eines Transistors mit Freilaufdiode anzugeben, die einen möglichst geringen Platzbedarf aufweist, guten Anschluß bei geringem zusätzlichen Verdrahtungsaufwand hat.

Die Aufgabe wird gelöst durch die kennzeichnenden Merkmale des Anspruchs 1. Ausgestaltungen und Weiterbildungen des Erfindungsgedankens sind in Unteransprüchen gekennzeichnet.

Vorteile der Erfindung sind eine hohe Integrierbarkeit ohne schaltungstechnischem Aufwand. Wesentlich dabei ist, daß jedem Einzeltransistor wenigstens eine Einzeldiode möglichst nahe benachbart ist, so daß durch kurze Verbindungen von Transistor und Diodenanschlüssen für beide Bauelemente die selbe Verdrahtung benutzt wird. Die Flächeneinsparung wird dadurch erreicht, daß Teile der Freilaufdioden sich unter der sonst ungenutzten Verdrahtungsfläche der Anschlußleiter befinden, bzw. nicht benötigt werden.

Ein weiterer Vorteil der Anordnung ist, daß die räumliche Verteilung der Freilaufdioden eine bessere Wärmeabfuhr ermöglicht. Eine thermische Kopplung, die zwischen jedem einzelnen Transistor und zugehöriger Freilaufdiode stattfindet, wirkt sich im Wechselbetrieb positiv aus.

Die Erfindung wird nachfolgend anhand von den in den Figuren der Zeichnung dargestellten Ausführungsbeispielen näher erläutert.

Es zeigt:

Figur 1    eine Leistungshalbbrücke,

Figur 2    eine Draufsicht auf einen Ausschnitt eines integrierten Leistungstransistor mit zugehöriger Leistungsfreilaufdiode gemäß dem Stand der Technik,

Figur 3    die Draufsicht auf einen Ausschnitt eines ersten erfindungsgemäßen integrierten Leistungstransistor mit zugehörigen Leistungsfreilaufdioden,

Figur 4    eine Draufsicht auf einen Ausschnitt eines zweiten erfindungsgemäßen integrierten Leistungstransistor mit zugehörigen Freilaufdioden,

Figur 5    einen Querschnitt durch eine Doppelisolationsdiode, und

Figur 6    einen Querschnitt durch einen Leistungstransistor mit zugehöriger Substratwannendiode.

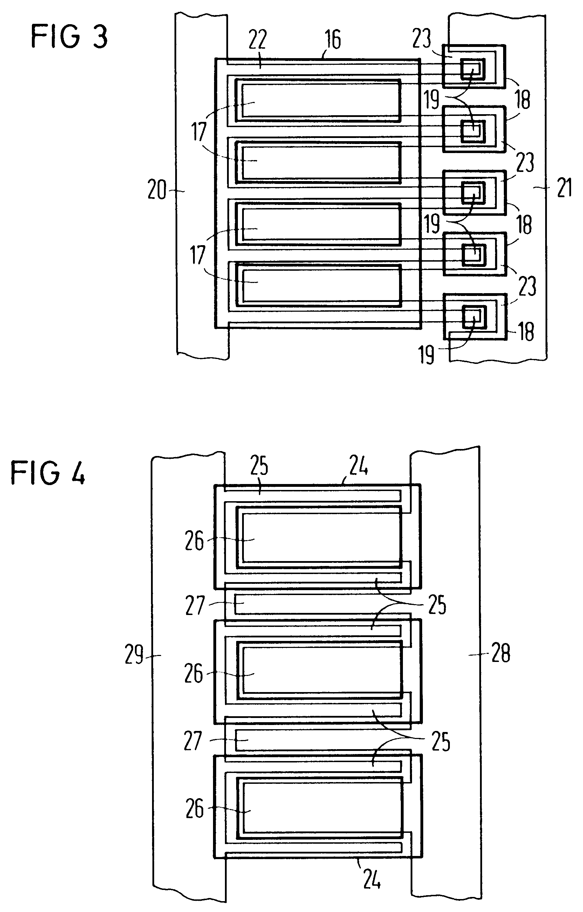

In der in Figur 3 gezeigten Draufsicht auf einen erfindungsgemäßen Leistungshalbleiter mit Freilaufdiode ist der in Figur 1 gezeigte Quellentransistor 1 und die zugehörige Freilaufdiode 3 zu sehen. Der Quellentransistor besteht hier z.B. aus vier parallelgeschalteten Einzeltransistoren, welche untereinander zeilenförmig in dem Block 16 angeordnet sind. Die Emitteranschlüsse sind mit 17 und die Kollektoranschlüsse mit 22 bezeichnet. Aus Übersichtlichkeitsgründen wurde auf die Darstellung des Basisbereichs verzichtet. In unmittelbarer Nachbarschaft auf der rechten Seite eines jeden Einzeltransistors befindet sich eine Freilaufdiode 18. Diese sind bei einem Quellentransistor in einer Halbbrükke als Doppelisolationsdioden ausgebildet, um so vom Substrat der integrierten Schaltung isoliert zu sein. Die Kathodenbereiche der Freilaufdioden sind mit 19 und die Anodenbereiche der Freilaufdioden mit 23 gekennzeichnet. Mit 20 und 21 sind die Versorgungsspannungsanleiter gekennzeichnet, die üblicherweise aus Aluminiumsilizid, bestehen.

Die Leiter 20, 21 führen links entlang der Längsseite des Leistungstransistors 16 bzw. entlang der Einzeldioden 18. Diese Leiter 20, 21 kontaktieren die jeweiligen Anschlußbereiche der Transistoren bzw. Freilaufdioden mit der zugehörigen Versorgungsspannungsanschluß- bzw. Ausgangsklemme. So bildet der Leiter 20 die Verbindung zu der in Figur 1 gezeigten Anschlußklemme 5 und der Leiter 21 die Verbindung zu der in Figur 1 gezeigten Anschlußklemme 6. Von dem Leiter 20 führen fingerförmige Abzweigungen rechtwinklig heraus, die die Kollektorkontaktierzone 22 der Einzeltransistoren mit dem Leiter 20 verbinden. Die zu den jeweiligen Einzeltransistoren zugehörigen Freilaufdioden 18 sind nun derart versetzt zu den Einzeltransistoren angeordnet, daß die fingerförmigen Abzweigungen nur verlängert werden müssen, um die jeweiligen Kathodenkontaktierzone der Freilaufdioden mit dem Leiter 20 zu verbinden. Desgleichen verbinden fingerförmige Abzweigungen, die rechtwinklig von dem zweiten Leiter 21 abführen, die Emitterkontaktierzonen 17 der Einzeltransistoren und die Anodenkontaktierzonen 23 der Freilaufdioden mit dem Leiter 21.

Auf diese Weise erfolgt eine durch kurze Verbindungswege optimal gestaltete Anordnung einer Leistungsendstufe. Es sind keine zusätzlichen Verbindungsleiter für die Freilaufdioden notwendig, da durch die räumliche Anordnung von Einzeltransistoren und Freilaufdioden lediglich eine Verlängerung der bereits bestehenden Verbindungsleiter notwendig ist, um sämtliche notwendigen Kontaktierungen herzustellen.

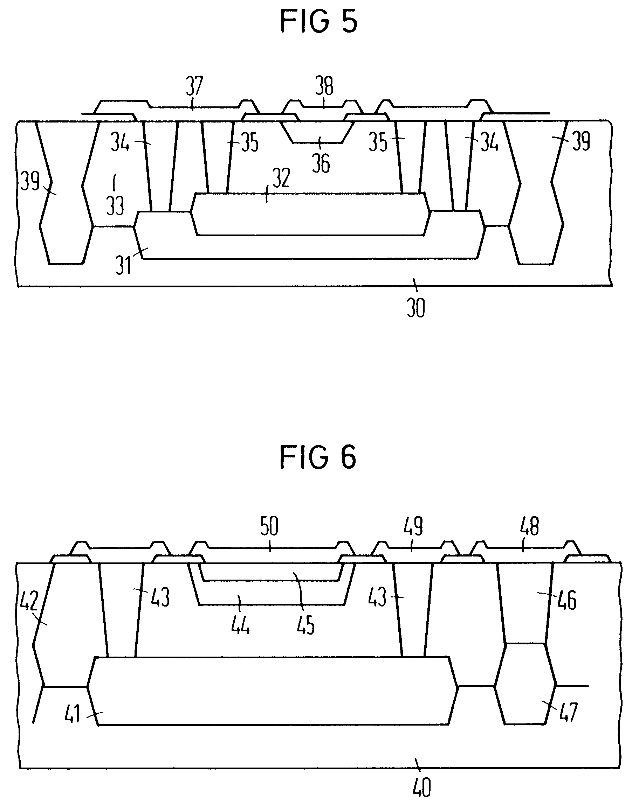

Um den Aufbau der in Figur 3 verwendeten Doppelisolationsdioden näher zu erläutern, zeigt Figur 5 einen Querschnitt durch eine solche Diode. Auf einem Substrat 30 ist eine Epitaxieschicht 33 aufgebracht. In dieser befindet sich ein buried layer 31, der mit den Zonen 34 eine Wanne bildet und so mit den Anodenanschlußbereichen 37 verbunden ist. Auf dem buried layer 31 befindet sich ein unterer Isolationsbereich 32, der ebenfalls mit dem oberen Isolationsbereich 35 eine innerhalb der ersten Wanne befindliche zweite Wanne bildet. Die oberen Isolationsbereiche 35 verbinden dabei die Anodenanschlußbereiche 37 mit dem unteren Isolationsbereich 32. Innerhalb der zweiten Wanne befindet sich die Kathode 36 mit zugehörigem Kathodenanschlußbereich 38. Eine obere und untere Isolation 39 umgibt die gesamte Struktur, so daß diese von den benachbarten Strukturen isoliert wird. Das aktive Gebiet der Doppelisolations-Diode besteht aus der NPN-Folge der Gebiete 36, 32, 31, so daß auch ohne die umgebenden Isolationen 39 mehrere Dioden in einer Wanne 33 realisiert werden können, ohne daß die Eigentümlichkeit einzelner Dioden verloren geht. Entsprechendes gilt für die Finger des Quellentransistors, die in einer gemeinsamen Wanne liegen können.

Für den in Figur 1 gezeigten Senkentransistor 2 und zugehörige Freilaufdiode 4 ergibt sich, wie Figur 4 zeigt, durch örtliche Zuordnung wenigstens einer Einzeldiode zu jedem Einzeltransistor, eine noch günstigere platzsparendere erfindungsgemäße Anordnung. Da die Anode der Freilaufdiode mit Masse verbunden ist, ist keine Konstruktion wie die der oben angegebenen Doppel-Isolations-Diode notwendig. Als Diode genügt der Übergang einer Wanne (Kathode) zum Substrat (Anode) selbst. Daher können die Kollektoren der Einzeltransistoren, die diese Wanne bilden, jeweils als Kathoden für die Freilaufdioden benutzt werden. Die Einzeltransistoren sind in Figur 4 mit 24, deren Emitteranschlußbereiche mit 26 und deren Kollektoranschlußbereiche mit 25 bezeichnet. Da die Kollektoranschlußbereiche auch gleichzeitig die Kathodenanschlußbereiche der sogenannten Substrat-Wannen-Dioden bilden, sind diese Freilaufdioden in dieser Draufsicht nicht als Einzelelemente zu erkennen. Die Kathodenbereiche der Freilaufdioden sind mit 25 und die Anodenanschlußbereiche mit 27 gekennzeichnet. Es sind wiederum Anschlußleiter 28 und 29 dargestellt, wobei der Leiter 28 die Verbindung zu der in Figur la dargestellten Anschlußklemme 7 herstellt und der Leiter 29 die zu der in Figur 1 dargestellten Anschlußklemme 6. Die Leiter sind wiederum links und rechts entlang der Einzeltransistoren und Einzeldioden angeordnet, welche wiederum zeilenförmig untereinander angeordnet sind. Erfindungsgemäß gehen von dem Anschlußleiter 28 wiederum fingerförmige Abzweigungen ab, die abwechselnd die Emitterkontaktierzone 26 der Einzeltransistoren und die Anodenkontaktierzone 27 der zugehörigen Freilaufdiode mit dem Leiter 28 verbinden. Ebenso gehen von dem Leiter 29 fingerförmige Abzweigungen ab, die nun die gemeinsame Kollektor-Kathodenkontaktierzone der Einzeltransistoren bzw. Freilaufdioden mit dem Leiter 29 verbinden. Werden die fingerförmigen Abzweigungen, die von 28 aus die Emitter 26 kontaktieren, von den Anschlüssen des Substrats (Anode 27) getrennt, kann eine Schaltung mit getrennten Anschlüssen für den Emitter des Senkentransistors und die Anode seiner zugehörigen Freilaufdiode realisiert werden.

Aus Übersichtlichkeitsgründen wurde in den Figuren 2 bis 4 auf die Darstellung der Basisanschlußbereiche und deren Anschlußleiter der Transistoren verzichtet. Diese können in üblicher Weise zwischen den fingerförmigen Abzweigungen der Anschlußleiter geführt werden.

Um auch hier den Aufbau des Transistors mit zugehöriger Substratwannendiode gemäß Figur 4 näher zu erläutern, zeigt Figur 6 einen Querschnitt durch eine derartige Struktur. Auf einem Substrat 40 ist eine Epitaxieschicht 42 aufgebracht. In dieser befindet sich ein buried layer 41, der mit den Kollektorzonen 43 eine Wanne bildet, die die Kollektoranschlußbereiche 49 mit dem buried layer 41 verbinden. Innerhalb dieser Wanne befindet sich der Emitterbereich 45 und der Basisbereich 44 des Transistors. Als Anschlußzone ist hier nur die des Emitters mit 50 bezeichnet. Der Kollektorbereich 43 und sein zugehöriger Anschlußbereich 49 bilden gleichzeitig die Kathode der Freilaufdiode. Die Anode der Freilaufdiode umgibt die Transistorstruktur ringförmig mit dem oberen Isolationsbereich 46 und dem unteren Isolationsbereich 47, welche das Substrat mit dem Anodenanschluß 48 verbinden.

Da die Anode der Substrat-Wannen-Diode die trennende Isolation zwischen den Wannen der einzelnen Transistorfinger ist, können diese Wannen im Gegensatz zum Quellentransistor nicht in einer gemeinsamen Wanne liegen.

Die gezeigten Anordnungen sind nicht auf Halbbrückenschaltungen beschränkt sondern können für jeden Leistungstransistor mit Freilaufdiode verwendet werden.

**Patentansprüche**

1. Anordnung mindestens eines Bipolartransistors und mindestens einer Freilaufdiode in einem integrierten Schaltkreis mit Anschlußleitern, wobei jeder Transistor aus mehreren parallelgeschalteten Einzeltransistoren und die Freilaufdiode aus mehreren parallelgeschalteten Einzelfreilaufdioden bestehen, **dadurch gekennzeichnet**, daß zu jedem Einzeltransistor mindestens eine zugehörige Einzelfreilaufdiode in unmittelbarer Nachbarschaft derart angeordnet ist, daß die Anschlußleiter (20, 21; 28, 29) für Emitter (17; 26) und Kollektor (22; 23) jedes Einzeltransistors jeweils unmittelbar zur Anode (23; 27) bzw. Kathode (19; 25) geführt sind.

2. Anordnung nach Anspruch 1, **dadurch gekennzeichnet**, daß die Einzeltransistoren in Form eines Blocks zeilenförmig angeordnet sind, daß die Freilaufdioden (18) als Doppelisolationsdioden ausgebildet sind, daß die Freilaufdioden (18) zeilenförmig entlang einer Blockseite unmittelbar neben den Einzeltransistoren angeordnet sind, daß an gegenüberliegenden Blockseiten jeweils ein den Laststrom zu- bzw. abführende aus Metall bestehender Anschlußleiter vorgesehen ist, daß beide Anschlußleiter fingerförmige Abzweigungen haben, die jeweils den Kollektor bzw. Emitter eines Einzeltransistors und die Kathode bzw. die Anode der zugehörigen Freilaufdiode mit dem Anschlußleiter verbinden, so daß die fingerförmigen Abzweigungen der beiden Anschlußleiter gegenseitig kammartig ineinandergreifen.

3. Anordnung nach Anspruch 1, **dadurch gekennzeichnet**, daß die Einzeltransistoren und zugeordneten Freilaufdioden einen Block bilden, daß die Freilaufdioden als Substratwannendioden ausgebildet sind, wobei der Kollektor jedes Transistors die Kathode der zugehörigen Freilaufdiode bildet und die Anode den Kollektor des Transistors umgibt, daß an gegenüberliegenden Blockseiten jeweils ein den Laststrom ab- bzw. zuführende aus Metall bestehender Anschlußleiter vorgesehen ist, daß von dem ersten Anschlußleiter fingerförmige Abzweigungen ausgehen, die die Kollektor- und die Kathodenzone des Transistors bzw. der Freilaufdiode mit dem ersten Anschlußleiter verbinden, daß von dem zweiten Anschlußleiter fingerförmige Abzweigungen ausgehen, die abwechselnd die Emitterzone bzw. die Anodenzone mit dem zweiten Anschlußleiter verbinden, so daß die fingerförmigen Abzweigungen der beiden Anschlußleiter kammartig ineinandergreifen.

4. Anordnung nach Anspruch 2 oder 3,
   **dadurch gekennzeichnet**,
   daß die fingerförmigen Abzweigungen rechtwinklig von dem Anschlußleiter abzweigen und geradlinig ausgebildet sind.

FIG 1

FIG 2

FIG 3

FIG 4

# FIG 5

# FIG 6

**Europäisches Patentamt**

# EUROPÄISCHER RECHERCHENBERICHT

Nummer der Anmeldung

EP    91 12 0695

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | GB-A-2 177 848 (SGS MICROELETTRONICA S.P.A.) 28. Januar 1987 | 1 | H01L27/06 |
| Y | * Seite 1, Zeile 101 - Seite 2, Zeile 59; Ansprüche 1,4-5; Abbildungen 1-5 * <br> --- | 2-3 | H01L27/07 <br> H01L27/02 |
| Y | EP-A-0 283 066 (SGS-THOMSON-MICROELECTRONICS S.P.A.) 21. September 1988 <br> * Seite 2, Spalte 2, Zeile 51 - Seite 3, Spalte 3, Zeile 7; Ansprüche 1-4; Abbildungen 2-3 * <br> --- | 2 | |
| Y | US-A-3 665 330 (U.S. PHILIPS CORPORATION) 23. Mai 1972 <br> * Spalte 4, Zeile 2 - Spalte 4, Zeile 21; Abbildung 3 * <br> --- | 3 | |
| A | US-A-4 035 827 (RCA CORPORATION) 12. Juli 1977 <br> * Spalte 2, Zeile 26 - Spalte 2, Zeile 50 * <br> * Spalte 5, Zeile 31 - Spalte 5, Zeile 41; Abbildungen 2-3 * | 1 | |
| | ----- | | **RECHERCHIERTE SACHGEBIETE (Int. Cl.5)** <br><br> H01L |

Der vorliegende Recherchenbericht wurde für alle Patentansprüche erstellt

| Recherchenort | Abschlußdatum der Recherche | Prüfer |
|---|---|---|
| DEN HAAG | 27 MAERZ 1992 | FRANSEN |